(19) Europäisches Patentamt

European Patent Office

Office européen des brevets

(11) EP 1 324 443 A2

(12) EUROPEAN PATENT APPLICATION

(43) Date of publication:
02.07.2003 Bulletin 2003/27

(51) Int Cl.⁷: H01S 5/0687

(21) Application number: 02017374.6

(22) Date of filing: 02.08.2002

(84) Designated Contracting States:
AT BE BG CH CY CZ DE DK EE ES FI FR GB GR
IE IT LI LU MC NL PT SE SK TR
Designated Extension States:
AL LT LV MK RO SI

(30) Priority: 25.12.2001 JP 2001390957

(71) Applicant: MITSUBISHI DENKI KABUSHIKI
KAISHA
Tokyo 100-8310 (JP)

(72) Inventors:
• Masuda, Kenij,
c/o Mitsubishi Denki Kabushiki K.
Tokyo 100-8310 (JP)
• Sato, Makoto, c/o Mitsubishi Denki Kabushiki K.
Tokyo 100-8310 (JP)

(74) Representative: Pfenning, Meinig & Partner
Mozartstrasse 17
80336 München (DE)

(54) Optical semiconductor module with wavelength monitoring

(57) An optical semiconductor module has a laser diode (1) for emitting light, a first photo-diode (2) and a second photo-diode (3) for receiving light emitted by the laser diode (1), and a wavelength filter (5) which is disposed on a light path between the laser diode (1) and the first photo-diode (2) and continuously changes the intensity according to wavelength of the light. The first photo-diode (2) generates an output current which is 20 % or above larger than that of the second photo-diode (3) at the same intensity of the entered lights.

## FIG.1

EP 1 324 443 A2

**Description**

FIELD OF THE INVENTION

The present invention relates to improvement in detecting accuracy of a wavelength monitor section of an optical semiconductor module to be applied to an optical transmission apparatus.

BACKGROUND OF THE INVENTION

Fig. 9 shows a structure of an optical semiconductor module which disclosed in Japanese Patent Application Laid-Open No. 10-79551 and monitors an intensity and an oscillation wavelength of an output light from a semiconductor laser. Light emitted backward from an optical semiconductor laser 126 is converted into a parallel light by a lens 127 and enters a 1/4 wavelength plate 128 where a linear polarized light is converted into a circular polarized light, and the circular polarized light enters a first polarization beam splitter (PBS) 129.

In the PBS 129, the circular polarized light is separated into a first emitted light 130 and a second emitted light 131. A first emission end surface is provided with a band pass filter film 132, and the first emitted light 130 transmits through the band pass filter film 132 and is received by a first photo-diode 133. A photocurrent output of the first photo-diode 133 fluctuates according to oscillation wavelength of the semiconductor laser 126.

The second emitted light 131 enters a second PBS 134 to be separated into a third emitted light 135 and a fourth emitted light 136. A third emission end surface is provided with a band pass filter film 137, and the third emission light 135 transmits through the band pass filter film 137 and is received by a second photo-diode 138. A photocurrent output of the second photo-diode 138 fluctuates according to the oscillation wavelength of the semiconductor laser 126.

The fourth emitted light 136 is received directly by a third photo-diode 139.

The photocurrent outputs of the first photo-diode 133 and the second photo-diode 138 are used as wavelength monitor, and the photocurrent output of the third photo-diode 139 is used as intensity monitor of the light emitted backward from the semiconductor laser. As a result, both the wavelength and the light intensity are stabilized.

Since a conventional optical semiconductor module has the above structure, a number of parts are large and thus there arises a problem that the cost of the product becomes high. Further, when three planes where respective parts are mounted are displaced due to temperature changes and aging, there arises a problem that the intensity of the lights received by the respective photo-diodes fluctuates.

SUMMARY OF THE INVENTION

It is an object of the present invention to provide an optical semiconductor module which does not require a structure that a plurality of PBSs and a plurality of band pass filters are combined and is capable of monitoring oscillation wavelength of an output light of a semiconductor laser accurately with a simple structure and is stable to temperature changes and aging.

An optical semiconductor module as one aspect of this invention includes a laser diode (LD) for emitting light, a first photo-diode (PD) and a second PD for receiving the light emitted by the LD, and a wavelength filter disposed on a light path between the LD and the first PD to continuously change intensity of the light according to wavelength of the light. The first PD generates 20% larger output current than the second PD when they receive the light of the same intensity.

An optical semiconductor module as another aspect of this invention includes an LD for emitting light, a first PD and a second PD for receiving the light emitted by the LD, and a wavelength filter disposed on a light path between the LD and the first PD to continuously change intensity of the light according to wavelength of the light. Ratio of light receiving area of the first PD to that of the second PD is 1.2 or above.

An optical semiconductor module as still another aspect of this invention includes an LD for emitting light, a first PD and a second PD for receiving the light emitted by the LD, and a wavelength filter disposed on a light path between the LD and the first PD to continuously change intensity of the light according to wavelength of the light. The first PD is composed of plural PD elements.

An optical semiconductor module as still another aspect of this invention includes an LD for emitting light, a first PD and a second PD for receiving the light emitted by the LD, and a wavelength filter disposed on a light path between the LD and the first PD to continuously change intensity of the light according to wavelength of the light. The first PD is located on opposite to a principal ray emitted from the LD.

Other objects and features of this invention will become apparent from the following description with reference to the accompanying drawings.

BRIEF DESCRIPTION OF THE DRAWINGS

Fig. 1 is a block diagram which shows structures of a wavelength monitor section and light intensity monitor section of an optical semiconductor module according to a first embodiment of the present invention,

Fig. 2 is a characteristic example of an output of a first PD 2 and an output of a second PD 3 when a combination of birefringence crystal and polarizer, for example, is used as a wavelength filter 5,

Fig. 3A and Fig. 3B are graphs which show the output of the first PD 2 and a frequency response of slope efficiency,

Fig. 4 is a block diagram which shows structures of the wavelength monitor section and the light intensity monitor section of the optical semiconductor module according to a second embodiment of the present invention,

Fig. 5 is a block diagram which shows structures of the wavelength monitor section and the light intensity monitor section of the optical semiconductor module according to a third embodiment of the present invention,

Fig. 6 is a block diagram which shows structures of the wavelength monitor section and the light intensity monitor section of the optical semiconductor module according to a fourth embodiment of the present invention,

Fig. 7 is a Gaussian distribution schematic diagram,

Fig. 8 is a block diagram which shows structures of the wavelength monitor section and the light intensity monitor section of the optical semiconductor module according to a fifth embodiment of the present invention, and

Fig. 9 is a diagram which shows the structure of the optical semiconductor module which is disclosed in Japanese Patent Application Laid-Open No. 10-79551 and which monitors intensity and oscillation wavelength of an output light from a semiconductor laser.

DETAILED DESCRIPTION

Embodiments of this invention will be explained below with reference to the accompanying drawings.

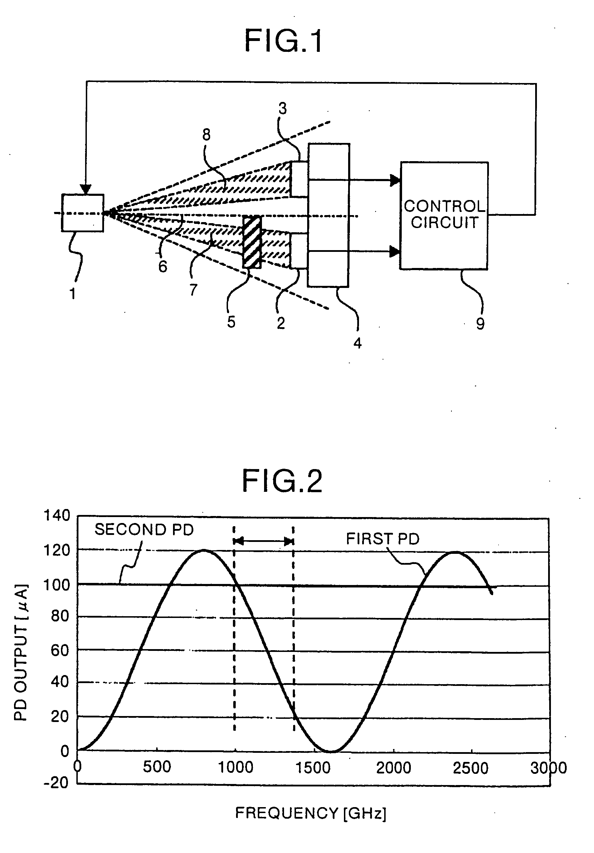

A first embodiment of this invention will be explained below. Fig. 1 is a block diagram which shows structures of a wavelength monitor section and light intensity monitor section of an optical semiconductor module according to the first embodiment. In Fig. 1, in the optical semiconductor module according to the first embodiment, a first PD 2 and a second PD 3 which have the same light receiving area are mounted to an a PD mounting surface of a PD carrier 4 to be arranged at equal distances from an axis 6 of a principal ray of light emitted from an LD 1 so that a light emitted from the rear surface of the LD 1 is received by the first PD 2 and the second PD 3. A wavelength filter 5 is disposed on a light path between the LD 1 and the first PD 2, and light 7 for entering the first PD 2 transmits through the wavelength filter 5, and thereby an output of the first PD changes according to wavelength. Moreover, since light 8 for entering the second PD 3 enters the second PD 3 directly, an output of the second PD 3 becomes an output according to the intensity of the light from the LD 1.

Fig. 2 shows a characteristic example of the outputs of the first PD 2 and the second PD 3 when a combination of birefringence crystal and polarizer, for example, is used as the wavelength filter 5. Since the first PD 2 receives the transmitted light of the wavelength filter 5, it outputs a signal with a waveform shown in the figure in which intensity changes continuously according to the wavelength as a wavelength monitor output. Since the second PD 3 receives the emitted light from the LD directly, it outputs a signal that is proportional to the intensity of the emitted light from the LD as an output of the light intensity monitor. Here, when light of the same intensity as that of the second PD enters the first PD, the first PD can generate an output current that is 1.2 or above times as large as the second PD. A control circuit 9 inputs the wavelength monitor output and the light intensity monitor output therein, and controls an operating current and an operating temperature of the LD 1 so that the wavelength monitor output and the light intensity monitor output are kept constant.

The wavelength of the emitted light from the LD is controlled by using an area where the intensity of wavelength monitor output changes linearly and approximately with respect to the wavelength (in Fig. 2, a range shown by two broken lines) . The output of the second PD 3 receiving the emitted light directly from the LD 1 is constant regardless of the wavelength of the light, but the output of the first PD 2 for receiving the light transmitted through the wavelength filter 5 changes continuously according to response of transmittance because the response of the transmittance of the wavelength filter becomes a function of $\sin^2$ theoretically.

Therefore, when the output is monitored in order to control wavelength in the range shown by the broken lines in the figure, the output of the first PD 2 becomes fairly small in a direction of long wavelength. As a result, when S/N is low, a signal has the hazard of being masked by a noise.

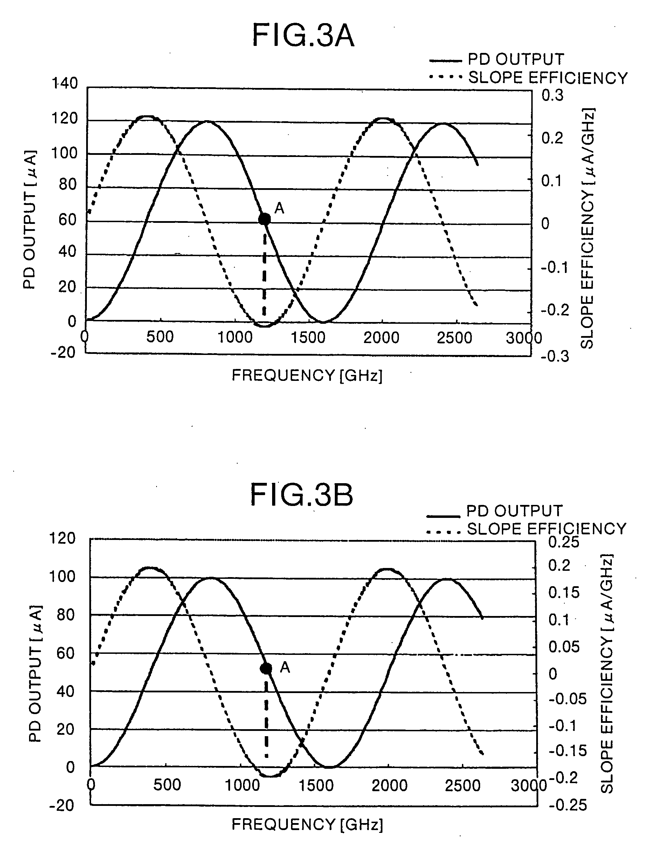

Fig. 3A and Fig. 3B show the output of the first PD 2 and frequency response of slope efficiency. Fig. 3A is based on Fig. 2, and shows data when PD which can generate an output 20% or above higher than the output of the second PD is used as the first PD2. The slope efficiency represents a slant of the slope of the PD output, and in Fig. 3A and Fig. 3B, it is obtained by differentiating $\sin^2$. Fig. 3B shows an example as a comparative example that PDs having the same specification are used as the first PD 2 and the second PD 3.

Points A in Figs. 3A and 3B are maximum points of the slope efficiency, and the slope efficiency in Fig. 3A is improved by 20% at the point A in comparison with Fig. 3B. For example, when fluctuation 1 μA of the PD output in the vicinity of the point A is converted into wavelength, the fluctuation is 5.1 GHz in Fig. 3B but 4.2 GHz in Fig. 3A, namely, the fluctuation in Fig. 3A can be smaller than Fig. 3B. For this reason, accuracy of monitoring wavelength is improved. Therefore, when the setting is made to avoid the low output range where the signal is masked by a noise, the wavelength can be monitored with higher reliability.

As mentioned above, according to the first embodiment of the present invention, since the first PD and the second PD are mounted to the same mounting surface of the PD carrier, the dimensional stability is increased and a degree of the stability to the temperature changes and aging can be heightened. Further, since the output of the first PD can be 20% or above higher than the output of the second PD, the slope efficiency rises, and the accuracy of monitoring the wavelength is improved. Further, when the monitoring range is set to avoid the low output range, the wavelength can be monitored with higher reliability.

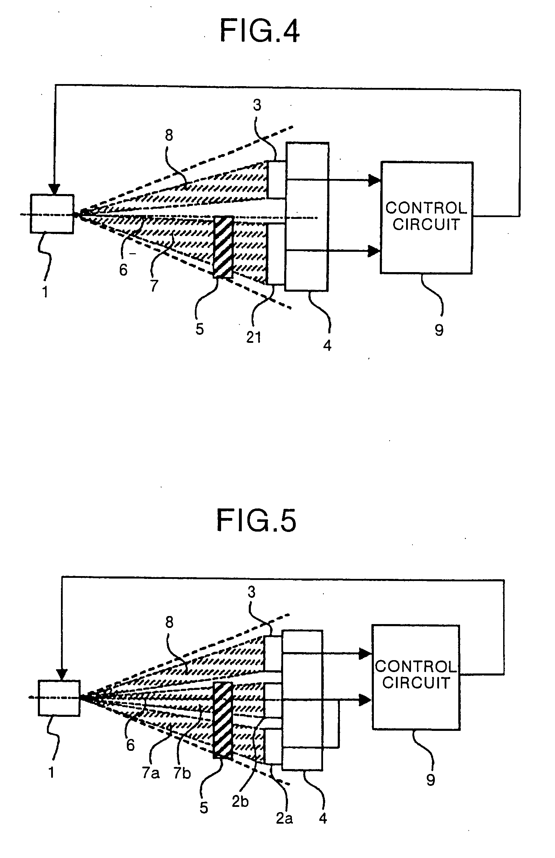

A second embodiment of this invention will be explained below. Fig. 4 is a block diagram which shows structures of a wavelength monitor section and light intensity monitor section of an optical semiconductor module according to the second embodiment. In the figure, the same reference numerals are given to the sections which are the same or corresponding to those in Fig. 1 according to the first embodiment, and the description thereof is omitted. This is applied also to the figures hereinafter.

In the second embodiment, the light receiving area of a first PD 21 is 1.2 or above times as large as the second PD 3. Since the output current of the PD is approximately proportional to the light receiving area, when the light receiving area is set to be 1.2 times or above, the output current also becomes 1.2 times or above. Therefore, as explained in the first embodiment of the present invention, the slope efficiency is heightened, and the accuracy of monitoring the wavelength is improved. Further, the monitoring range is set to avid the low output area so that the wavelength can be monitored with higher reliability.

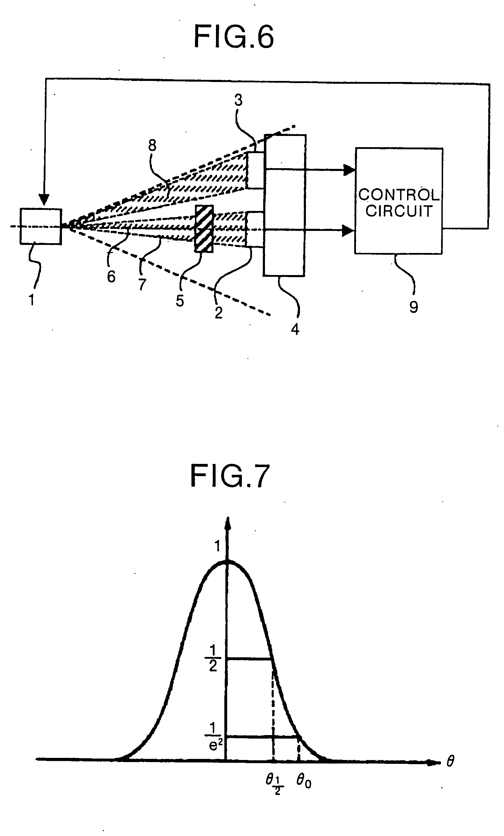

A third embodiment of this invention will be explained below. Fig. 5 is a block diagram which shows structures of a wavelength monitor section and light intensity monitor section of an optical semiconductor module according to the third embodiment. In the third embodiment, the first PD 2 is composed of plural PD elements (2a, 2b) and the plural PD elements are connected in parallel so as to take out an output. The respective PD elements may have the same light receiving area as that of the second PD 3, or alternatively even if the light receiving area is small, an output of the PD elements in the parallel connection may be improved by 20% or above in comparison with an output of the same light receiving area as the second PD 3. Moreover, Fig. 5 shows two PD elements, but their number may be larger . Furthermore, one of the plural PD elements may be disposed so as to be opposite to an axis of a principal ray of LD 1.

As mentioned above, in the third embodiment of the present invention, the first PD is composed of the plural PD elements so that the output can be heightened. For this reason, the slope efficiency rises and the accuracy of monitoring wavelength is improved. Further, the monitoring range is set to avid the low output area so that the wavelength can be monitored with higher reliability.

A fourth embodiment of this invention will be explained below. Fig. 6 is a block diagram which shows structures of a wavelength monitor section and light intensity monitor section of an optical semiconductor module according to the fourth embodiment. In the fourth embodiment, the first PD 2 is disposed so as to be opposite to the axis of the principal ray of the light emitted from the LD 1. Since the intensity of the light emitted from the LD 1 is Gaussian-distributed as shown in Fig. 7, when the two PDs are disposed at equal distances from the axis of the principal ray, the PDs should receive the emitted light having intensity lowered according to an opening angle viewed from the LD 1 side.

A beam spreading angle $\theta_{DEG}$ of the light emitted from the LD 1 is about 22° by averaging the angle by half angle $1/e^2$, and a beam spot size ωo is represented by the equation (1).

$$\omega_0 = \frac{\lambda}{\pi \cdot \theta_{RAD}} = \frac{\lambda}{\pi \cdot \theta_{DEG} \cdot \frac{\pi/}{180}} \qquad (1)$$

Where $\theta_{DEG}$ = 22 and $\lambda$ = 1.55 × 10^{-6}, the beam spot size ωo = 1.28 × 10^{-6}.

A beam radius ω in a LD-PD distance z with this beam spot size is calculated according to the equation (2).

$$\omega = \omega_0 \sqrt{1 + \left( \frac{z\lambda}{\pi\varpi_0{}^2} \right)^2} \qquad\qquad \cdots \quad (2)$$

Where the LD-PD distance z is 3 mm, $\omega \cong 1.2$ mm.

When a shape of the PD light receiving section is circular, coupling efficiency $\eta_{PD}[\omega]$ is represented by the equation (3).

$$\eta_{PD}[\omega] = \frac{\int_{-\sqrt{\Delta r^2 - (x-r_1)^2}}^{+\sqrt{\Delta r^2 - (x-r_1)^2}} \int_{r_1 - \Delta r}^{r_1 + \Delta r} \exp\left( -\frac{2(x^2 + y^2)}{\omega^2} \right) dxdy}{\int_{-\infty}^{\infty} \int_{-\infty}^{\infty} \exp\left( -\frac{2(x^2 + y^2)}{\omega^2} \right) dxdy}$$

$$\cdots \quad (3)$$

Where $\omega$: the beam radius on the PD surface, $r_1$: a distance between the beam center (principal ray) and PD, and $\Delta r$: a radius of the PD light receiving section.

It is supposed that the two PDs are disposed at equal distances from the axis of the principal ray. When $\omega = 1.2$ mm, $r_1 = 0.4$ mm and $\Delta r = 0.15$ mm are used in the equation (3), $\eta_{PD} = -16.0643$ dB. On the contrary, when the lower PD is disposed to be opposite to the axis of the principal ray, for example, $r_1 = 0$, and therefore the coupling efficiency $\eta_{PD}$ of the lower PD is -15.1192 dB. As a result, the coupling efficiency is improved by 0.95 dB in comparison with the equal distance disposition. This corresponds to 24% increase. Since the output of the PD is proportional to the intensity of the light entering the light receiving section, it is allowed that the output current of the PD is increased by 24%.

Therefore, when the first PD 2 is disposed to be opposite to the axis of the principal ray of the light emitted from the LD 1 like the fourth embodiment, the output current of the first PD 2 can be 20 % or above higher than the state that the first PD 2 and the second PD 3 are disposed at equal distances from the axis of the principal ray. Therefore, the slope efficiency rises and the accuracy of monitoring wavelength is improved, and when the monitoring range is set to avoid the low output area so that the wavelength can be monitored with higher reliability.

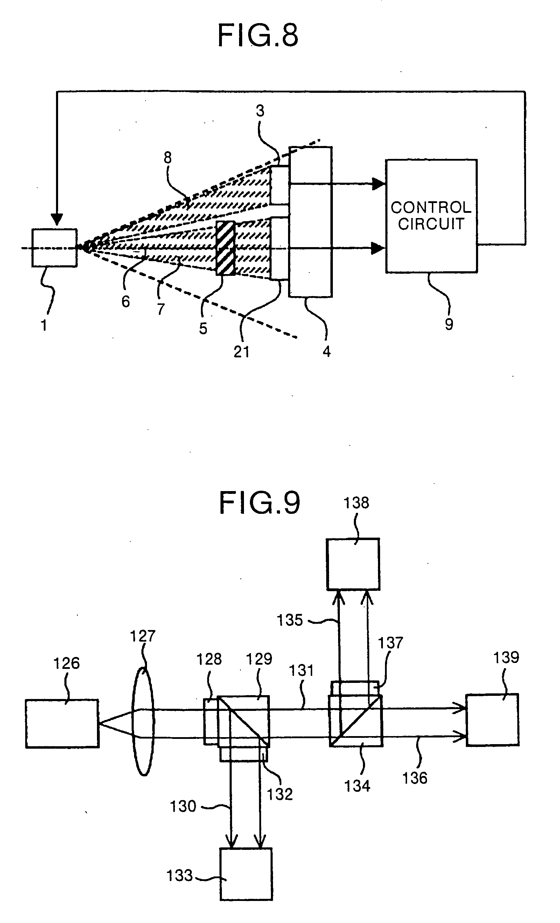

A fifth embodiment of this invention will be explained below. Fig. 8 is a block diagram which shows structures of a wavelength monitor section and light intensity monitor section of an optical semiconductor module according to the fifth embodiment. In the fifth embodiment, the light receiving area of a first PD 21 is 1.2 or above times as large as that of the second PD 3, and the first PD 21 is disposed so as to be opposite to the axis of the principal ray of the light emitted from the LD 1. As mentioned above, since the output current can be large approximately proportionally to the light receiving area and the first PD is opposite to the axis of the principal ray where the maximum intensity of the Gaussian distributed light emitted from the LD 1, it is allowed that the output current of the first PD 21 can be surely improved by 20 % or above. The slope efficiency rises and the accuracy of monitoring the wavelength is improved, and when the monitoring range is set to avoid the low output area so that the wavelength can be monitored with higher reliability.

As mentioned above, according to the present invention, since the first PD and the second PD are mounted to the same mounting surface of the PD carrier, the dimensional stability is increased and a degree of the stability to temperature changes and aging can be improved. Further, since the output current for the light entered from the first PD for receiving the light transmitted through the wavelength filter is improved by 20 % or above, the slope efficiency rises and the accuracy of monitoring the wavelength is improved.

Although the invention has been described with respect to a specific embodiment for a complete and clear disclosure, the appended claims are not to be thus limited but are to be construed as embodying all modifications and alternative constructions that may occur to one skilled in the art which fairly fall within the basic teaching herein set forth.

**Claims**

1. An optical semiconductor module comprising:

   a laser diode (1) for emitting light;
   a first photo-diode (2) and a second photo-diode (3) for receiving the light emitted by the laser diode (1); and
   a wavelength filter (5) disposed on a light path between the laser diode (1) and the first photo-diode (2) to continuously change intensity of the light according to wavelength of the light,

   wherein the first photo-diode (2) generates 20% larger output current than the second photo-diode (3) when they receive the light of the same intensity.

2. An optical semiconductor module comprising:

   a laser diode (1) for emitting light;
   a first photo-diode (21) and a second photo-diode (3) for receiving the light emitted from the laser diode (1) ; and
   a wavelength filter (5) disposed on a light path between the laser diode (1) and the first photo-diode (21) to continuously change intensity of the light according to wavelength of the light,

   wherein ratio of light receiving area of the first photo-diode (21) to that of the second photo-diode (3) is 1.2 or above.

3. An optical semiconductor module comprising:

   a laser diode (1) for emitting light;
   a first photo-diode (21, 2b) and a second photo-diode (3) for receiving the light emitted by the laser diode (1) ; and
   a wavelength filter (5) disposed on a light path between the laser diode (1) and the first photo-diode (2a, 2b) to continuously change intensity of the light according to wavelength of the light,

   wherein the first photo-diode (2a, 2b) is composed of plural photo-diode elements (2a, 2b).

4. An optical semiconductor module comprising:

   a laser diode (1) for emitting light;
   a first photo-diode (2) and a second photo-diode (3) for receiving the light emitted by the laser diode (1); and
   a wavelength filter (5) disposed on a light path between the laser diode (1) and the first photo-diode (2) to continuously change intensity of the light according to wavelength of the light,

   wherein the first photo-diode (2) is located on opposite to a principal ray emitted from the laser diode (1).

5. The optical semiconductor module according to any one of claims 1 to 4 further comprising a control circuit (9) for inputting the output currents from the first photo-diode (2) and the second photo-diode (3) to generate a signal for controlling an operation of the laser diode (1).

# FIG.1

# FIG.2

# FIG.3A

# FIG.3B

# FIG.4

# FIG.5

# FIG.6

# FIG.7

# FIG.8

# FIG.9